# EUROPEAN PATENT APPLICATION

(11) **EP 4 550 416 A1**
(43) Date of publication of application: **07.05.2025**
(21) Application number: 24208631.2
(22) Date of filing: 24.10.2024
(51) Int. Cl.: H01L 23/538, H01L 23/42, H01L 23/498, H01L 23/367, H01L 21/48, H01L 23/15, H01L 23/522

(54) **PACKAGING SUBSTRATE AND MANUFACTURING METHOD OF PACKAGING SUBSTRATE**

(30) Priority: 31.10.2023 US 202363594431 P; 02.11.2023 US 202363595336 P
(71) Applicant: Absolics Inc., Covington, GA 30014 (US)
(72) Inventor: KIM, Tae Kyoung, Covington, Georgia, 30014 (US); LEE, Bongyeol, Covington, Georgia, 30014 (US)
(74) Representative: BCKIP Part mbB

(57) **Abstract**

This specification relates to a packaging substrate and a manufacturing method for the packaging substrate. The packaging substrate according to this specification includes a core layer comprising a glass core having a first surface and a second surface facing each other, as well as a cavity portion penetrating through the glass core. An element module is disposed of the cavity portion. The element module comprises one or more cavity elements and a cavity distribution layer that are modularized into a capsule layer, wherein the cavity distribution layer is disposed above the cavity element, and the cavity distribution layer comprises a redistribution distribution circuit layer. A manufacturing method of a packaging substrate comprises preparing operation of a glass core with a cavity portion and an element module; and arranging operation of the element module in the cavity portion. The element module is modularized with one or more cavity elements and a cavity distribution layer encapsulated in a capsule layer, and the cavity distribution layer is a distribution layer disposed on an upper surface of the cavity element. They can significantly reduce a defect rate that may occur during package connection by increasing the pad pitch formed on the cavity element.

## Description

This application claims the priority of U.S. Provisional Patent Application No. 63/594,431 and No. 63/595,336, filed October 31, 2023 and November 2nd, 2023 respectively.

### BACKGROUND

### 1. Field

This document relates to a packaging substrate, a semiconductor package, a manufacturing method of a packaging substrate, and a manufacturing method of a semiconductor package and the like.

### 2. Description of Related Art

When building an electronic component, implementing the circuitry on a semiconductor wafer is called the front end (FE), and assembling the wafer into a product ready state is called the back end (BE). The latter includes the packaging process.

There are four core technologies in the semiconductor industry that have enabled the rapid development of electronic products in recent years: semiconductor technology, semiconductor packaging technology, manufacturing process technology, and software technology. Semiconductor technology is advancing in various forms, including sub-micron to nano scale line widths, more than 10 million cells, high speed operation, and high heat dissipation, but the technology to package them perfectly is relatively inadequate. Therefore, the electrical performance of semiconductors is often determined by packaging technology and electrical connections rather than the performance of the semiconductor technology itself.

Substrates for packaging may be made of ceramic or resin. Ceramic substrates, such as silicon substrates, have high resistivity or high dielectric constant, making it difficult to mount high performance, high frequency semiconductor elements. In the case of resin substrates, it is possible to mount relatively high performance, high frequency semiconductor elements. However, there are limitations in reducing the pitch of the wiring.

Recently, glass plates may be applied as substrates for high end packaging. By forming through holes in the glass substrate and applying conductive materials to the through holes, the wiring length between the element and the motherboard can be shortened and have good electrical characteristics.

Related prior art includes Korean Patent Publication No. 10-2023-0008017 and Japanese Patent No. JP05114041.

### SUMMARY

It is an object of embodiments to provide a packaging substrate and a manufacturing method of a packaging substrate that solve misalignment issue due to differences in metal pitch that can occur when embedding cavity elements.

It is also an object of the embodiments to provide a packaging substrate and a manufacturing method of a packaging substrate that reduces a defect rate that may occur during package connection by increasing a pad pitch formed on a cavity element.

It is also an object of embodiments to provide a packaging substrate and a manufacturing method of a packaging substrate that reduce heat generation and electrical losses by shortening electrical path lengths through the embedding of cavity elements.

To achieve the above objectives, a packaging substrate according to one embodiment includes a core layer.

The core layer includes a glass core having first and second surfaces facing each other and a cavity portion through the glass core.

An element module is arranged at the cavity portion.

The element module is modularized with one or more cavity elements and a cavity distribution layer encapsulated in a capsule layer.

The cavity distribution layer may be a redistribution layer disposed on an upper surface of the cavity element.

The cavity distribution layer may include at least two redistribution circuit layer.

The redistribution circuit layer may include: i) a cavity bump layer; or ii) a via and a circuit layer.

The cavity bump layer is an electrically conductive layer that is in contact with the upper part of the cavity element, enabling the transmission of electrical signals to the cavity element.

The via and circuit layer is an electrically conductive layer connecting the cavity bump layer and the circuit layer to transmit electrical signals.

The via may connect the electrically conductive layers in the circuit pattern vertically (x-z or y-z direction).

The circuit layer may connect the electrically conductive layers in the circuit pattern horizontally (x-y direction).

The cavity distribution layer may include: a first redistribution circuit layer where the cavity bump layer is disposed; and a second redistribution circuit layer in which the first via and the first circuit layer are embedded in the module insulation layer.

The module insulation layer is an insulating layer positioned within the element module.

The cavity distribution layer may further include a third redistribution circuit layer in which the second via and the second circuit layer are embedded in the module insulation layer.

At the glass core, a core electrically conductive layer, which is electrically conductive layer disposed on the surface of the glass core.

A pitch of the redistribution circuit layer may be narrower than a pitch of the core electrically conductive layer.

A pitch of the second redistribution circuit layer may be larger than a pitch of the first redistribution circuit layer.

A pitch of the third redistribution circuit layer may be larger than a pitch of the second redistribution circuit layer.

A pad area of the second redistribution circuit layer may be larger than a pad area of the first redistribution circuit layer.

A pad area of the third redistribution circuit layer may be larger than a pad area of the second redistribution circuit layer.

The element module may include an active element.

The element module may additionally include passive element.

The packaging substrate may further include an upper layer, which is disposed of upper side of the core layer.

The pitch of the electrically conductive pattern arranged on the bottom surface of the upper layer may be greater than the minimum pitch of the cavity distribution layer.

The packaging substrate may additionally include a lower layer positioned beneath the core layer.

The pitch of the electrically conductive pattern arranged on the upper surface of the lower layer may be greater than the minimum pitch of the cavity distribution layer.

Other embodiment for achieving the above purpose is a manufacturing method of a packaging substrate.

The manufacturing method includes: a preparing operation of a glass core having a cavity portion and an element module; and an arranging operation of the element module in the cavity portion.

The element module may be modularized with one or more cavity element and a cavity distribution layer encapsulated in a capsule layer.

The cavity distribution layer is a distribution layer disposed on an upper surface of the cavity element.

The cavity distribution layer may include at least two redistribution circuit layer.

The redistribution circuit layer may include: i) a cavity bump layer; or ii) a via and a circuit layer.

The cavity bump layer is an electrically conductive layer that is in contact with the upper part of the cavity element, enabling the transmission of electrical signals to the cavity element.

The via and circuit layer is an electrically conductive layer connecting the cavity bump layer and the circuit layer to transmit electrical signals.

The manufacturing method of the packaging substrate may additionally include forming operation of a core conductive layer.

The forming operation of a core conductive layer may be performed between the preparing operation and the arranging operation, or after the arranging operation.

The forming operation of a core conductive layer is operation of forming a core electrically conductive layer on the glass core.

A pitch of the redistribution circuit layer may be narrower than a pitch of the core electrically conductive layer.

The pitch of the redistribution circuit layer may widen as it extends away from the cavity distribution layer and the cavity element.

The element module may be manufactured in modularized operation.

The modularization operation includes an operation of generating a cavity distribution layer on top of the cavity element.

The cavity distribution layer may include at least two redistribution circuit layer.

The cavity distribution layer may be formed through the Semi Additive Process (SAP) method.

The element module may include an active element.

The element module may additionally include passive element and molded.

### BRIEF DESCRIPTION OF THE DRAWINGS

FIG. 1 is a conceptual diagram illustrating a cross-sectional structure of a packaging substrate, according to an embodiment.
FIG. 2 is a conceptual diagram illustrating a cross-sectional structure of a packaging substrate, according to another embodiment.
(a) and (b) of FIG. 3 are conceptual diagrams illustrating a cross-sectional view of a portion of a packaging substrate, according to an embodiment, respectively.
FIG. 4 is a cross-sectional flowchart illustrating a process for preparing a core distribution layer during the manufacturing of a packaging substrate, according to an embodiment.
FIG. 5 is a cross-sectional flowchart illustrating a process for preparing an insulating layer during manufacturing of a packaging substrate, according to an embodiment.
FIG. 6 is an example of a cross-sectional structure of a packaging substrate preparing in accordance with an embodiment.
FIG. 7 is an enlarged cross-section of the element module on the packaging substrate of FIG. 6.
FIG.8 is an enlarged cross-section of the element module on the packaging substrate of FIG. 6.
FIG. 9 is a cross-sectional flowchart to illustrate a semi-additive process (SAP) according to an embodiment example.
FIG. 10 is an example of a cross-sectional structure of a packaging substrate preparing according to another embodiment.

### DETAILED DESCRIPTION

In order to provide a comprehensive understanding of the methods, apparatus, and/or systems described herein, the following detailed description is provided. However, various modifications, modifications, and equivalents of the methods, devices, and/or systems described herein will become apparent after understanding what this disclosure presents. For example, the sequence of operations described herein is by way of example only and is not intended to be limiting to the operations described herein. With the exception of operations that are not necessarily performed in a particular order, the order of operations may be altered based on an understanding of what is disclosed herein. In addition, descriptions of features already known in the art may be omitted for clarity and brevity after understanding the disclosure of this application. However, the omission of such features and their descriptions is not intended to be recognized as general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the disclosures of this application.

The terms "first," "second," "third," and the like may be used herein to describe various members, components, regions, layers, or sections, but are not intended to limit the members, components, regions, layers, or sections to these words.

Instead, these terms are used for the purpose of distinguishing one member, component, region, layer, or section from another member, component, region, layer, or section. Thus, a first member, a first component, a first zone, a first layer, or a first section referred to in the embodiments described herein may also be referred to as a second member, a second component, a second zone, a second layer, or a second section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit disclosure. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but not all examples are limited thereto.

For the purposes of this application, "B being located on A" means that B is disposed on top of A either in direct contact with A or with another layer or structure interposed therebetween, and should not be construed to mean that B is in direct contact with A.

Unless otherwise defined, all terms used herein shall have the same meaning as commonly understood by one of ordinary skill in the art to which the present invention belongs. Terms such as those defined in commonly used dictionaries are to be construed to have meanings consistent with their meaning in the context of the prior art and the present invention and are not to be construed in an idealized or overly formal sense unless expressly defined herein.

In one or more of the examples above, a description of "A and/or B" means "A, B, or A and B".

In one or more of the above examples, terms such as "first," "second," "A," or "B" are used to distinguish identical terms from each other.

In one or more of the above examples, a singular form is contextually interpreted to include the plural as well as the singular, unless otherwise noted.

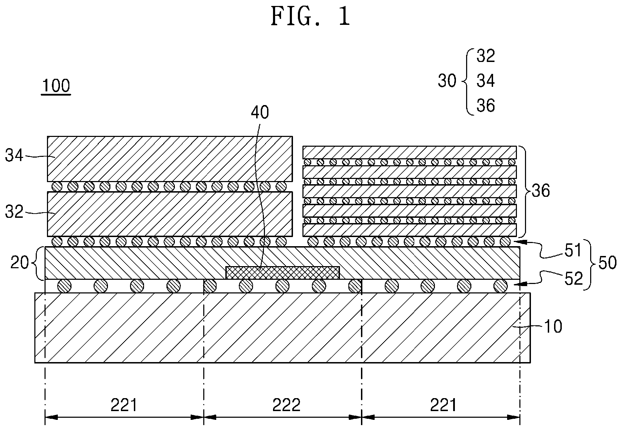

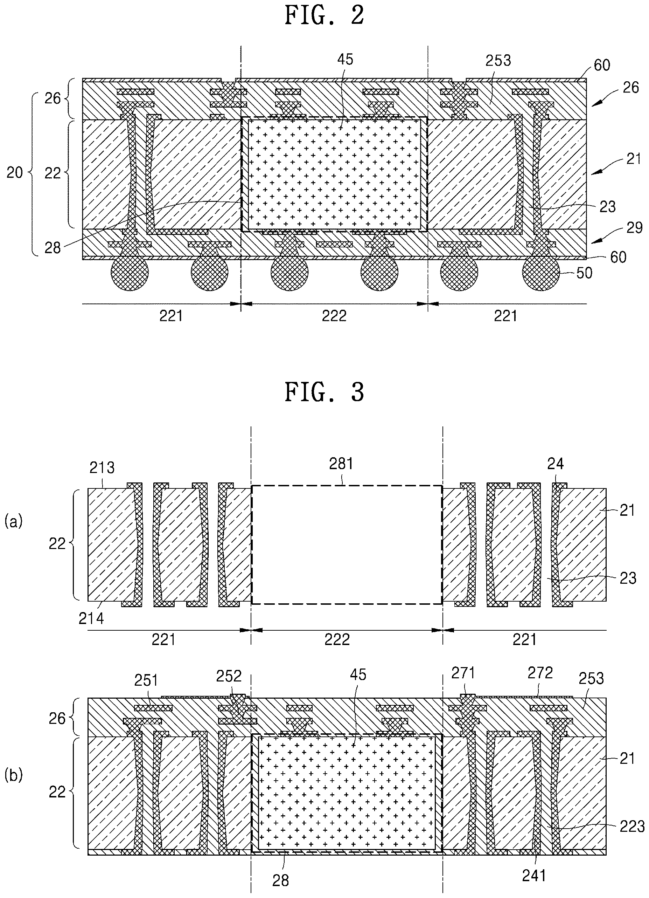

FIG. 1 is a conceptual diagram illustrating a cross-sectional structure of a packaging substrate according to an embodiment, FIG. 2 is a conceptual diagram illustrating a cross-sectional structure of a packaging substrate according to another embodiment, and (a) and (b) of FIG. 3 are conceptual diagrams illustrating a cross-sectional structure of a portion of a packaging substrate according to an embodiment, respectively.

To accomplish the above objectives, a semiconductor device 100 according to an embodiment comprises a semiconductor element portion 30 on which one or more semiconductor element 32, 34, 36 are located; a packaging substrate 20 electrically connected to the semiconductor elements; and a motherboard 10 electrically connected to the packaging substrate 20 and transmitting external electrical signals to and connecting the semiconductor elements 32, 34, 36 with each other.

The packaging substrate 20, according to one embodiment, comprises a core layer 22, an upper layer 26 located on a first surface of the core layer 22, and a cavity portion 28 in which a cavity element 40 or element module 45 may be located.

The semiconductor element portion 30 refers to an element mounted on a semiconductor device and is mounted on the packaging substrate 20 by means of a connection electrode or the like. Specifically, the semiconductor element portion 30 may be applied to, for example, a computing element (first element: 32, second element: 34) such as a CPU or GPU, a memory element (third element, 36) such as a memory chip, etc.

The motherboard 10 may be a motherboard such as a printed circuit board, a printed wiring board, or the like.

The packaging substrate 20 may optionally further comprise a lower layer (29) positioned below the core layer.

The core layer 22 may comprise, a glass core 21 comprising a first zone 221 having a first thickness and a second zone 222 having a second thickness that is adjacent to the first zone 221 and has a thickness less than the first thickness (half cavity) or has a thickness of 0 mm (full cavity); a plurality of core vias 23 penetrating the glass core 21 in the thickness direction; and a core distribution layer 24 located on a surface of the glass core 21 or of the core vias 23 and electrically connecting, via the core vias 23, a first surface 213 of the glass core 21 and a second surface 214 facing the first surface. FIGS. 2 and 3 illustrate a form in which the second zone of the glass core, referred to as the full cavity, is perforated.

The second zone 222 of the core layer 22 may serve as a cavity structure.

Within the same zone, the glass core 21 has a first surface 213 and a second surface 214 that face each other, and these two surfaces are substantially parallel to each other and have a constant thickness throughout the glass core 21.

The inner space 281 formed by the difference in thickness of the first zone 221 and the second zone 222 serves to house some or all of the cavity elements 40.

The glass core 21 may comprise core vias 23 through the first surface 213 and the second surface 214. The core vias 23 may be formed in both the first zone 221 and the second zone 222 and may be formed in any desired pitch and pattern.

As a packaging substrate for semiconductor devices, silicon substrates and organic substrates have traditionally been applied in a laminated form. In the case of silicon substrates, due to the nature of semiconductors, parasitic elements may occur when applied to high-speed circuits, and power losses are relatively high. In addition, organic substrates require large area to form more complex distribution patterns, which is inconsistent with the trend of miniaturization of electronic devices. In order to form a complex distribution pattern within a certain size, pattern refinement is practically necessary, but there were practical limitations in pattern refinement due to the characteristics of materials such as polymers applied to organic plates.

In an embodiment, a glass core 21 is applied as a support for the core layer 22 as a way to address these issues. In addition, a core via 23 formed through the glass core 21 is applied along with the glass core 21 to provide the packaging substrate 20 with shorter electrical flow lengths, more miniaturization, faster response, and lower loss characteristics.

The glass core 21 is preferably a glass substrate applied to semiconductors, and for example, a borosilicate glass substrate, an alkali-free glass substrate, and the like may be applied, but is not limited thereto.

The core via 23 penetrates the glass core 21. The core via 23 may be formed in such a way as to remove a predetermined area of the glass core 21, in particular by etching the plate glass by physical and/or chemical method.

Specifically, the formation of the core via 23 may be accomplished by forming defects (inclusions) on the surface of the glass core by means of a laser or the like, followed by chemical etching, laser etching, and the like, but is not limited to.

Based on a unit area (1 cm x 1 cm) of the glass core 21, the number of the core via 23 may be from 100 to 3,000, from 100 to 2,500, or from 225 to 1,024. If such a pitch condition is satisfied, the formation of an electrically conductive layer or the like and the performance of the packaging substrate can be improved.

The core distribution layer 24 comprises a core distribution pattern 241, which is an electrically conductive layer electrically connecting the first and second surfaces of the glass core via through vias, and a core insulating layer 223 surrounding the core distribution pattern. The core layer 22 has an electrically conductive layer formed therein through the core vias, which acts as an electrical pathway across the glass core 21 and can connect the top and bottom of the glass core over a relatively short distance, resulting in faster electrical signal transfer and low loss.

The electrically conductive layer may be, for example, but not limited to, a copper plating layer.

The cavity portion 28 is not limited to any specific shape and may be substantially circular, triangular, square, hexagonal, octagonal, cross-shaped, etc.

The cavity element 40 may be generally cylindrical, cuboidal, or polygonal in shape.

The cavity portion may be implemented in a form that penetrates the first surface 213 and the second surface 214 of the glass core 21. In this case, the cavity portion may be formed according to a process similar to the forming operation of the core vias 23 and may differ from the core vias 23 in the area and shape that it penetrates the glass core 21.

In such an embodiment, an insulating layer may be prepared in the cavity portion after it is arranged in the cavity element 40 or an element module 45, i.e., an insulating layer may be prepared in the cavity portion through the process of preparing the core insulating layer 223 described above.

In cases where the cavity element 40 is directly placed in the cavity portion, a core distribution pattern 241 may be formed to electrically connect with the cavity element 40. The scenario in which the element module 45 is arranged in the cavity portion will be discussed later.

The cavity element 40 may comprise an active element, such as a transistor, or a passive element, such as a power transfer element, such as a multilayer ceramic capacitor (MLCC). Additionally, the cavity element 40 may comprise an active element such as computational elements like CPUs and GPUs, as well as memory elements like memory chips.

As will be described later, the cavity elements may be modularized and inserted.

If an element such as a transistor, which plays a role in converting electrical signals between the motherboard and the semiconductor element portion to an appropriate level, is applied to the cavity element 40, the packaging substrate 20 can be in a form in which a transistor or the like is applied in the way of the packaging substrate 20, thereby providing a semiconductor device 100 having a more efficient and faster speed.

In addition, power transfer elements, such as multilayer ceramic capacitors (MLCCs), play an important role in the performance of semiconductor devices. It is common for at least 200 or more power transfer elements, which are passive elements, to be applied to a semiconductor device, and their performance in transferring power is also affected by the characteristics of the electrically conductive layer surrounding the element. In one embodiment, non-circular shaped core via may be applied where a low resistance electrically conductive layer is required, such as in power transfer elements.

On the other hand, a passive element such as a capacitor may be inserted individually and applied to the cavity element 40, or a group of elements comprising a plurality of passive elements in a form embedded between an insulating layer (cavity element insulation layer) may be formed so that the electrodes are exposed and then inserted into the cavity element. The latter option is more workable for packaging substrate fabrication and more favorable for ensuring that the insulating layer is sufficiently and reliably located in the space between complex elements.

On the other hand, when active elements are applied as cavity elements, there are additional considerations such as wiring and heat dissipation. This will be discussed later.

The glass core 21 plays an intermediate role, an intermediary role, connecting the semiconductor element portion 30 and the motherboard 10 on the upper and lower sides, respectively, and the core via 23 acts as a passageway for transmitting electrical signals therebetween, thereby enabling smooth signal transmission. For the purpose of distinguishing from the core via of the second zone 222 described later, the core via disposed in the first zone 221 will be referred to as the first zone core via 231.

Above the first surface 213 is the upper layer 26.

The upper layer 26 may comprise an upper distribution layer 25 and an upper surface connecting layer 27 positioned on the upper distribution layer 25, and the uppermost surface of the upper layer 26 may be protected by a cover layer 60 having an opening formed through which the contact electrodes of the semiconductor element may directly contact.

The upper distribution layer 25 may comprise an upper insulating layer 253 positioned on the first surface; and an upper distribution pattern 251 embedded in the upper insulating layer 253 as an electrically conductive layer having a predetermined pattern and electrically connecting at least a portion thereof with the core distribution layer 24. The upper distribution layers 25 disposed above and below each other may be connected to each other via blind vias 252.

The upper insulating layer 253 may be applied as an insulating layer to a semiconductor device or packaging substrate, and may be, for example, an epoxy-based resin containing fillers, but is not limited to.

The insulating layer may be formed by forming a coating layer and curing it, or it may be formed by laminating an uncured or semi-cured insulating film to the core layer 22 and curing it. In this case, by applying a pressure-sensitive lamination method or the like, the insulating material can be embedded into the space inside the core vias 23 and the process can proceed efficiently.

In some embodiments, the plurality of insulating layers may be stacked and substantially indistinguishable between the insulating layers, and the plurality of insulating layers are collectively referred to as the upper insulating layer.

Additionally, the core insulating layer 223 and the upper insulating layer 253 may be applied to the same insulating material, in which case the boundary between them may be substantially indistinguishable. Alternatively, in other embodiments, the boundaries of the insulating layers may be created by setting different pressures and temperatures to cure the multiple insulating layers.

The upper distribution pattern 251 refers to an electrically conductive layer located within the upper insulating layer 253 in a preset shape, which may be formed, for example, in a build-up layer method. Specifically, the upper distribution pattern 251 may be formed by forming an insulating layer, removing an unnecessary portion of the insulating layer, forming an electrically conductive layer by copper plating or the like, optionally removing an unnecessary portion of the electrically conductive layer, forming an insulating layer again on top of the electrically conductive layer, removing an unnecessary portion of the insulating layer, forming an electrically conductive layer by plating or the like, and so on, to form the upper distribution pattern 251 with the electrically conductive layer formed in a vertical or horizontal direction in the desired pattern.

Since the upper distribution pattern 251 is located between the core layer 22 and the semiconductor element portion 30, it is formed to comprise a fine pattern in at least a portion thereof so that the transmission of electrical signals to the semiconductor element portion 30 may proceed smoothly and the intended complex pattern may be sufficiently accommodated. In this case, the fine pattern may have a width and spacing of less than 4 µm, 3.5 µm or less, 3 µm or less, 2.5 µm or less, or 2.3 µm or less, respectively. The width and spacing may be 1 µm or more, respectively (hereinafter, the description of the fine pattern will be the same).

The upper surface connecting layer 27 comprises an upper surface connecting pattern 272 electrically connected, at least partially, with the upper distribution pattern 251 and located on the upper insulating layer 253, and an upper surface connecting electrode 271 electrically connecting the upper surface connecting pattern 272 with the semiconductor element portion 30.

The upper surface connecting pattern 272 may be located on a first surface of the upper insulating layer 253, or at least a portion thereof may be exposed and embedded in the upper insulating layer. For example, if the upper surface connecting pattern is located on one side of the upper insulating layer, the upper insulating layer may be formed by plating or the like, and if the upper surface connecting pattern is embedded with a part of it exposed on the upper insulating layer, it may be that a part of the insulating layer or electrically conductive layer is removed by surface polishing, surface etching, or the like after forming a copper plating layer or the like.

The upper surface connecting pattern 272 may comprise at least a portion of a fine pattern, such as the upper distribution pattern 251 described above. The upper surface connecting pattern 272 comprising such fine patterns enables a larger number of elements to be electrically connected in a smaller area, allowing for smoother electrical signal connections between elements or to the outside world, and more integrated packaging.

The upper surface connecting electrode 271 may be directly connected to the semiconductor element portion 30 by terminals or the like or may be connected via an element connecting portion 51 such as a solder ball.

The second zone 222 has a thinner thickness of the glass core 21 compared to the first zone 221, and the cavity element 40 may be located in the inner space 281 formed due to the difference in thickness. Furthermore, the core vias 23 and the core distribution layer 24 formed on the glass core 21 serve as an electrical connection structure connecting the cavity element 40 and the external element.

Furthermore, as described above, a cavity portion in the form of penetrating the first zone 221, i.e., the first surface 213 and the second surface 214 of the glass core 1, rather than the second zone 222, may be created, and the cavity element 40 may be arranged in the cavity portion.

The packaging substrate 20 is also connected to a motherboard 10. The motherboard 10 may be electrically connected to the core distribution pattern 241 located on at least a portion of the second surface 214 of the core layer 22 by terminals of the motherboard 10, either directly or via a board connecting portion 52 such as a solder ball. In addition, the core distribution pattern 241 in contact with the motherboard 10 may be connected to the motherboard 10 via a lower layer (not shown) located at the bottom of the core layer 22. The element connecting portion 51 and the board connecting portion 52 are collectively referred to as a connecting portion 50.

In one example, no substantially additional substrate other than the glass core 21 may be applied to the packaging substrate 20 positioned between the semiconductor element portion 30 and the motherboard 10.

Traditionally, the interposer and organic substrate are laminated together between the element and the motherboard. This multi-step application is understood to be necessary for at least two reasons: one is that there are scale issues with directly bonding the fine pattern of the element to the motherboard, and the other is that wiring damage can occur during the bonding process or during the driving of the semiconductor device due to differences in thermal expansion coefficients. The embodiment solves these problems by applying a glass core having a coefficient of thermal expansion similar to that of a semiconductor element and forming a fine pattern on the first surface of the glass core and an upper layer thereof having a fine scale enough for mounting the element.

In the following, a manufacturing method of a packaging substrate according to an embodiment of the present invention will be described.

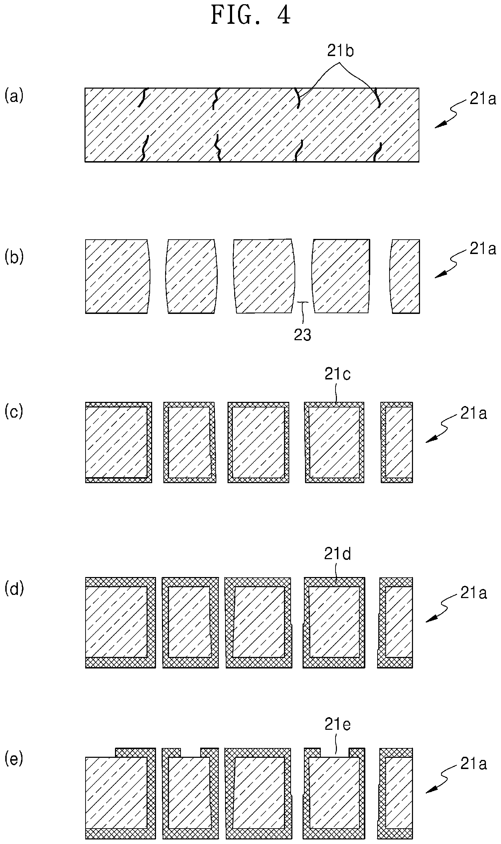

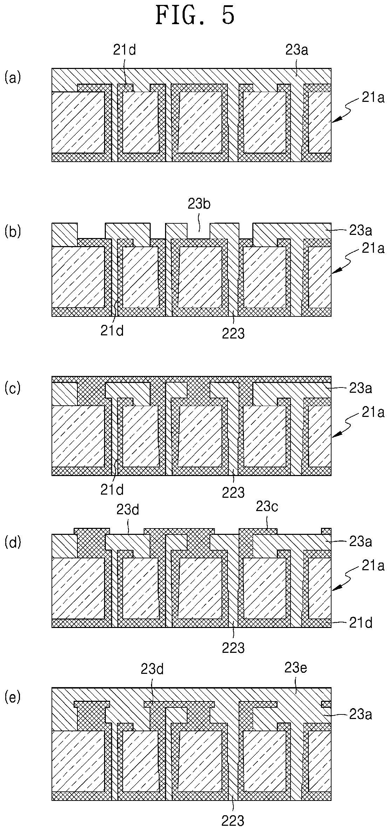

FIGS. 4 and 5 are flowcharts illustrating a cross-sectional view of the manufacturing process of a packaging substrate according to an embodiment.

First, a glass core 21a having a flat first and second surfaces is prepared, as shown in (a) of FIG. 4, and a defect (groove, 21b) is formed on the glass surface at a predetermined position for forming a core via. The glass core may be a glass core applied to a substrate of an electronic device or the like, and for example, an alkali-free glass core or the like may be applied but is not limited thereto. As a commercially available product, a product manufactured by a manufacturer such as Corning, Schott, AGC, etc. may be applied. The formation of the defects (grooves) may be accomplished by mechanical etching, laser irradiation, or the like.

As shown in (b) of FIG. 4, the glass core 21a on which the defect (groove, 21b) is formed is subjected to an etching operation to form the core vias 23 through a physical or chemical etching process. During the etching process, the glass core forms vias in the defect areas, and at the same time, the surface of the glass core 21a may be etched. A masking film or the like may be applied to prevent such etching of the glass surface, but in consideration of the cumbersome process of applying and removing the masking film, the defective glass core itself may be etched, and in this case, the thickness of the glass core having the core vias may be somewhat thinner than the thickness of the initial glass core.

Then, the core layer preparation operation may be performed by forming an electrically conductive layer 21d on the glass core as shown in (c) and (d) of FIG. 4. The electrically conductive layer may be a metal layer comprising, but not limited to, copper metal.

The surface of the glass (comprising the surface of the glass core and the surface of the core via) and the surface of the copper metal may have different properties, which may result in poor adhesion. In an embodiment, the adhesion between the glass surface and the metal can be improved by two methods: a dry method and a wet method.

The dry method is a method of applying sputtering, that is, metal sputtering, to form a seed layer 21c on the surface of the glass and the inner diameter of the core via. In the formation of the seed layer, dissimilar metals such as titanium, chromium, nickel, and the like may be sputtered together with copper, and in this case, glass-to-metal adhesion may be improved by an anchor effect in which the surface morphology of the glass and the metal particles interact.

The wet method is a primer treatment method in which a primer layer 21c is formed by pretreatment with a compound having functional groups such as amines. Depending on the degree of adhesion desired, pretreatment with a silane coupling agent may be followed by primer treatment with a compound or particle having an amine functional group.

As mentioned above, the support substrate of the embodiment needs to be of high enough performance to form a fine pattern, which should be maintained after the primer treatment. Therefore, if such primer comprises nanoparticles, it is preferred that nanoparticles having an average diameter of 150 nm or less are applied, for example, particles having amine functional groups. The primer layer may be formed by applying a bonding force improver, for example, such as the CZ series of MEC.

The seed layer/primer layer 21c may optionally form the electrically conductive layer with or without removing the portion where the formation of the electrically conductive layer is unnecessary. Furthermore, the seed layer/primer layer 21c may be optionally activated or deactivated for metal plating with or without removing the portion where the formation of the electrically conductive layer is necessary or unnecessary to proceed with the subsequent process. For example, the activation or deactivation treatment may be subjected to light irradiation treatment such as a laser of a certain wavelength, chemical treatment, or the like. The formation of the metal layer may comprise, but is not limited to, copper plating methods applied in the manufacture of semiconductor devices.

As shown in (e) of FIG. 4, a portion of the core distribution layer may be removed if it is unnecessary, and after the seed layer is partially removed or inactivated, metal plating may be performed to form an electrically conductive layer in a predetermined pattern to form the etching layer 21e of the core distribution layer.

FIG. 5 illustrates manufacturing operations to form an insulating layer and an upper distribution pattern, according to one embodiment.

As shown in (a) of FIG. 5, the core via may be subjected to a forming operation of an insulating layer in which the void space is filled with an insulating layer after the formation of the core distribution layer, which is an electrically conductive layer. In this case, the insulating layer applied may be made in the form of a film, for example, by pressure sensitive lamination of the insulating layer in the form of a film. By performing such pressure-sensitive lamination, the insulating layer can be sufficiently impregnated into the void space inside the core vias to form a core insulating layer without void formation.

(b) through (e) of FIG. 5 illustrate the upper layer manufacturing operations.

The operation of preparing the upper layer is to form an upper layer comprising an upper insulating layer and an upper distribution pattern on the core layer. The upper insulating layer may be formed by coating a resin composition forming the insulating layer 23a or by laminating an insulating film, and a simple method of laminating an insulating film is preferred. The lamination of the insulating film may be carried out by laminating the insulating film and curing it, in which case, by applying a pressure sensitive lamination method, the insulating resin may be sufficiently impregnated even to a layer in which no electrically conductive layer is formed inside the core via. The upper insulating layer is also applied in direct contact with the glass core, at least in part, and thus has sufficient adhesion. Specifically, the glass core and the upper insulating layer are preferably characterized by an adhesion test value of 4B or more according to ASTM D3359.

The upper distribution pattern may be formed by repeating the process of forming the insulating layer 23a, forming the electrically conductive layer 23c in a predetermined pattern, and etching off the unnecessary parts to form the etching layer 23d of the electrically conductive layer, or, in the case of the electrically conductive layers that are formed adjacent to the insulating layer, forming a blind vias 23b on the insulating layer and then proceeding with the plating process. Dry etching methods such as laser etching, plasma etching, and the like, or wet etching methods using a masking layer and an etching solution, may be applied to form the blind vias.

Then, although not shown, an upper surface connecting layer and a cover layer may be formed.

The upper surface connecting pattern and the upper surface connecting electrode may also be formed by a process similar to the formation of the upper distribution pattern. Specifically, it may be formed by forming an etching layer of an insulating layer on the insulating layer 23e, forming an electrically conductive layer thereon, and then forming an etching layer of the electrically conductive layer, and so on, but it may also be applied by selectively forming only the electrically conductive layer without applying the method of etching. The cover layer may be formed such that an opening (not shown) is formed at a position corresponding to the upper surface connecting electrode so that the upper surface connecting electrode is exposed and may be directly connected to an electrical connection or a terminal of the element.

Once the upper layer has been prepared, the lower layer may be processed by forming the lower surface connecting layer and cover layer. The lower layer and/or the lower surface connecting layer, and optionally the cover layer (not shown), may be formed in a similar manner to the operations for forming the upper surface connecting layer and cover layer 60 described above.

As described above with reference to FIGS. 2 and 3, a cavity element may be embedded in the cavity portion, and the cavity element may comprise an active element or a passive element. On the other hand, the electrodes connected to the active elements require fine metallic wiring, which may have a size difference from the metallic wiring formed on the glass core. As a result of this difference in size, or pitch, of the metal wires that need to be connected to each other, misalignment may occur when embedding the cavity element, and defects may occur when connecting the package. In addition, cavity elements placed within the inner space of the cavity portion may generate heat when operated, and this heat may also cause problems with signal transmission.

Accordingly, the present disclosure proposes an embodiment for preventing misalignment between a fine metal pattern to be connected to an active element or the like and a metal pattern having a pitch difference, and for preventing defects thereof. In accordance with one embodiment of the present disclosure, it is proposed to pre-form and embedded a fine metal pattern on the cavity element, such as an active element, that is to be connected to the cavity element, such as an active element. In addition, an embodiment is proposed in which a redistribution line is arranged so that the pitch of the via connecting to the fine metal bumps and the pitch of the circuit layer is gradually enlarged as the layer away from the active element increases to facilitate connection of the densely packed bumps.

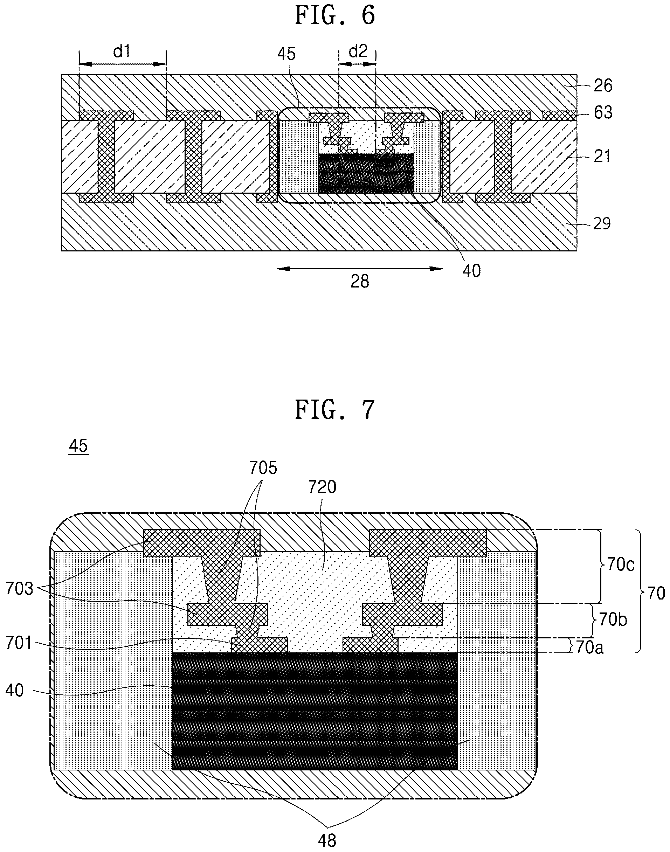

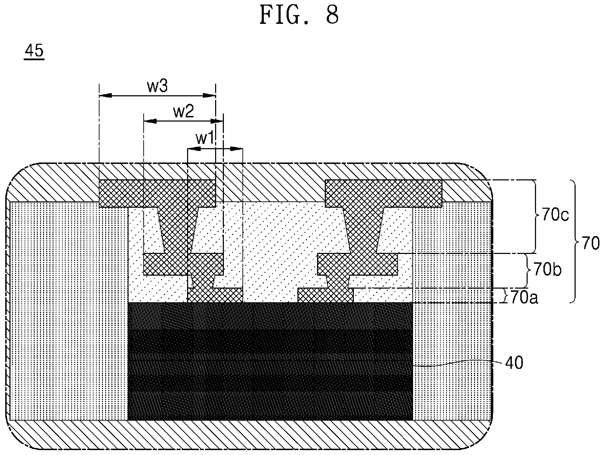

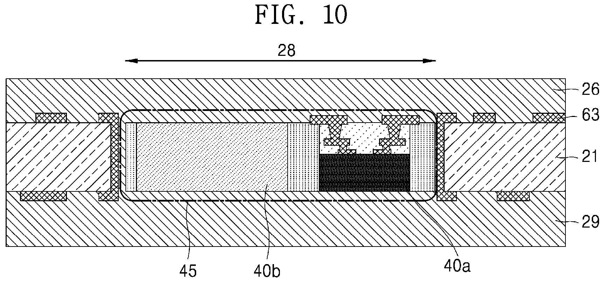

FIG. 6 is an example of a cross-sectional structure of a packaging substrate preparing according to an embodiment, FIG. 7 is an enlarged cross-section of the element module on the packaging substrate of FIG. 6, and FIG. 8 is an enlarged cross-section of an element module on the packaging substrate of FIG. 6. FIG. 10 is an example of a cross-sectional structure of a packaging substrate prepared according to another embodiment.

The packaging substrate of FIGS. 6 to 8 are conceptually simplified drawings to illustrate a packaging substrate preparing in accordance with an embodiment, and the package substrate of FIG. 10 is a conceptually simplified drawing to illustrate a packaging substrate with added heat dissipation of the cavity element, wherein all of the teachings described with reference to FIGS. 1 through 3 may be applied.

The core layer 22 may comprise a glass core 21 having first and second surfaces facing each other and may further comprise a core vias penetrating the glass core 21.

A core electrically conductive layer 63 may be disposed on the surface of the glass core 21. The core electrically conductive layer 63 is a general term that encompasses the core distribution layer 24 and the core distribution pattern 241.

The core electrically conductive layer 63 may optionally be formed on an inner wall surface of the core via. Further, for example, the cavity portion 28 according to FIG. 6 may be formed by penetrating both the first and second surfaces of the glass core 21. Optionally, a core metal layer 63 may be formed on the inner wall surface of the cavity portion 28. The element module 45 may be disposed inside the cavity portion 28. The cavity portion 28 may be formed simultaneously with the core via the same forming operations as the core via or may be formed independently after the core via is formed or before the core via is formed.

The element module 45 may comprise a cavity element 40 and a cavity distribution layer 70, which is a distribution layer formed on upside of the cavity element 40.

The element module 45 is modularized with one or more cavity elements 40 and a cavity distribution layer 70 encapsulated in a capsule layer 48. The cavity distribution layer 70 is a redistribution layer that is positioned on upper side of the cavity element 40 (see Figure 7).

Depending on the embodiment, the cavity element 40 may comprise an active element. The element module 45 disposed inside the cavity portion 28 according to FIG. 6 may be diced, encapsulated, and inserted into the cavity portion 28 after the cavity distribution layer 70 is formed.

The cavity distribution layer 70 may comprise two or more or three or more redistribution circuit layers. The redistribution circuit layer refers to: i) cavity bump layers 701; or ii) both via 705 and circuit layers 703 comprised in the cavity distribution layer.

The i) cavity bump layer 701 is a bump layer capable of transmitting electrical signals to the cavity element by contacting the upper surface of the cavity element 40.

The ii) via 705 and circuit layer 703 is connected to the cavity bump layer 701 and transmits electrical signals between the cavity bump layer and additional via and circuit layers or outside the core layer.

The via may connect the electrically conductive layer in the circuit pattern in the vertical direction (x-z or y-z).

The circuit layer may connect the electrically conductive layer in the circuit pattern in the planar direction (x-y).

The ii) via 705 and circuit layer 703 may be arranged at least one level within the rewiring distribution circuit layer and may be arranged at least two levels. Further, the ii) vias 705 and circuit layers 703 in the cavity distribution layer 70 may be arranged in 15 or fewer layers, or in 10 or fewer layers.

FIGS. 6 to 8 illustrate the placement of a total of three layers: one layer of i) cavity bump layer; and two layers of ii) via and circuit layers. However, it may be arranged in 2 layers, 4 layers, or more than 5 layers.

The cavity distribution layer 70 may comprise an electrically conductive layer (which comprises the cavity bump layer 701, vias 705, and circuit layer 703), and an insulating layer 73. The insulating layer is referred to as a module insulation layer 720 for the purpose of distinguishing it from the insulating layers of the core layer, upper layer, or lower layer. The module insulation layer 720 is an insulating layer that is positioned within the module.

The electrically conductive layer may, for example, comprise a metal layer. This metal layer refers to all metal patterns arranged in forms similar to circuit patterns. The metal layer comprises metal patterns and may contain both redistribution circuit layers and metal patterns that are not redistribution circuit layers. For example, the metal patterns that are not part of the redistribution circuit layer may include ground patterns, heat dissipation patterns, etc.

However, the cavity distribution layer 70 may be distinguished from other metal layers by differences such as the fact that the circuit layer of the cavity distribution layer is electrically connected to the cavity element and the circuits of the package substrate (such as traces present in the RDL)

As shown in Figure 7, the cavity distribution layer 70 may comprise a first redistribution circuit layer 70a, a second redistribution circuit layer 70b, and a third redistribution circuit layer 70c.

The first redistribution circuit layer 70a may be the layer in which the cavity bump layer 701 is placed.

The second redistribution circuit layer 70b may be the layer in which the vias 705 and the circuit layer 703 are embedded in the module insulation layer 720. The vias and circuit layers of the second redistribution circuit layer are referred to as the first via and the first circuit layer, respectively, in order to distinguish them from the vias and circuit layers of the third redistribution circuit layer.

The third redistribution circuit layer 70c may be the layer in which the vias 705 and the circuit layer 703 are embedded in the module insulation layer 720. The vias and circuit layers of the third redistribution circuit layer are referred to as the second via and the second circuit layer, respectively, in order to distinguish them from the vias and circuit layers of the second redistribution circuit layer. The vias may utilize blind vias. Pads may be arranged on the upper and lower portions of the vias, respectively.

The first redistribution circuit layer 70a, the second redistribution circuit layer 70b, and the third redistribution circuit layer 70c may be sequentially stacked vertically. In this case, the cavity bump layer 701 is in contact with the first via, the first via is in contact with the first circuit layer, the first circuit layer is in contact with the second via, and the second via may be in contact with the second circuit layer. Through these redistribution circuit layers, electrical signals may be transmitted to the cavity elements arranged within the element module.

The circuit layers and vias may be positioned within the insulating layer.

The insulating layers arranged in each of the layers, such as the first redistribution circuit layer 70a, the second redistribution circuit layer 70b, and the third redistribution circuit layer 70c, may be distinguishable from one another. However, depending on certain circumstances, such as the application of the same insulating material, these layers may not be distinguishable and may appear as a single entity.

The thickness of the circuit layers corresponding to the first circuit layer and the second circuit layer in the redistribution circuit layer area (excluding the cavity bump layer) may be 2 µm or more, 3 µm or more, or 4 µm or more. It may be less than or equal to 20 µm. The thickness of the insulating layers in each layer of the cavity distribution layer may be 5 µm or more, 7 µm or more, or 10 µm or more. Additionally, the thickness of the insulating layer in the cavity distribution layer may be less than or equal to 20 µm or less than or equal to 18 µm.

The precision of the redistribution circuit layers formed on the packaging substrate may be represented by the pitch, which is the spacing between the redistribution circuit layers. It is considered that the narrower the pitch, the finer the pattern.

According to an embodiment, a core electrically conductive layer 63 may be positioned within the glass core.

The pitch d1 of the core electrically conductive layer 63 may be larger than the pitch d2 of the cavity distribution layer 70 formed above the cavity element 40.

A finer electrically conductive layer may be formed on the cavity element 40 than on the core layer 22.

The pitch of the cavity element 40, for example, the pitch of the pads, may be smaller than the pitch of the pads formed on the core layer 22. In this case, applying an active element as the cavity element is more beneficial for efficient signal transmission. Here, the term "pad" refers to the electrically conductive layer formed around the edges of the via, either at the top or bottom of the via.

The pitch of the redistribution circuit layer may be narrower than the pitch of the core electrically conductive layer 63.

In the case of the redistribution circuit layer connected to an active element, a fine pitch is required. In this embodiment, to prevent misalignment between the core electrically conductive layer 63 formed on the glass core 21 and the active element, and to match the pitches closely, a fine metal pattern is formed in the form of a redistribution circuit layer on top of the active element.

Furthermore, the pitch of the redistribution circuit layer may increase as the number of layers in the cavity distribution layer 70 increases (i.e., as it moves farther away from the cavity element).

When the width of the electrically conductive layer in the first redistribution circuit layer 70a is denoted as wn1, the width of the electrically conductive layer in the second redistribution circuit layer 70b as wn2, and the width of the electrically conductive layer in the third redistribution circuit layer 70c as wn3. As the number of layers increases, the width of the metal layers also increases (wn1 < wn2 < wn3).

As illustrated in Figure 8, when the pad width of the first redistribution circuit layer 70a is denoted as w1, the pad width of the second redistribution circuit layer 70b as w2, and the pad width of the third redistribution circuit layer 70c as w3. As the number of layers increases, the width of the metal pads also increases (w1 < w2 < w3).

In other words, the electrically conductive layers of the cavity distribution layer 70 formed on the cavity element 40 broaden as they ascend to the upper layers and may ultimately be formed to be similar in width to the core electrically conductive layer 63 of the glass core. As the pattern width of the electrically conductive layers increases, the pitch of the metal pads may also increase.

The second redistribution distribution circuit layer 70b is a single-layer redistribution distribution circuit layer arranged on the cavity element, while the third redistribution distribution circuit layer 70c is a single-layer redistribution distribution circuit layer positioned above the second redistribution distribution circuit layer 70b. The pitch of the third redistribution distribution circuit layer 70c may be wider than that of the second redistribution distribution circuit layer 70b.

Also, the second redistribution distribution circuit layer 70b is a single-layer redistribution distribution circuit layer arranged on the first redistribution distribution circuit layer 70a. The pitch of the second redistribution distribution circuit layer 70b may be wider than that of the first redistribution distribution circuit layer 70a.

When embedding cavity elements that require a fine bump pitch into a glass core, a fine conductive layer is formed on the cavity element in advance. By widening the pitch of the conductive layer, it becomes easier to align with pads that have a larger pitch.

On upper side of the core layer 22, an upper layer 26 may be formed.

The pitch of the electrically conductive layer arranged on the underside of the upper layer may be greater than the minimum pitch of the redistribution distribution circuit layer. The pitch of the electrically conductive layer on the underside of the upper layer may be equal to or greater than the maximum pitch of the redistribution distribution circuit layer. In this case, the pitch of the electrically conductive layer on the underside of the upper layer refers to a metal layer that transmits electrical signals, excluding layers that are not intended for electrical signal transmission, such as the ground layer.

Underneath the core layer 22, a lower layer 29 may be disposed.

The pitch of the conductive layer arranged on the upper surface of the lower layer 29 may be larger than the minimum pitch of the conductive layer in the redistribution distribution circuit layer. In this case, the pitch of the conductive layer on the upper surface of the lower layer refers to the conductive layers that transmit electrical signals, such as metal layers, excluding layers that are not intended for electrical signal transmission, such as the ground layer.

On the other hand, the outermost conductive layer included in the cavity distribution layer 70 may be generated during the modular process of the element module 45. Additionally, the outermost conductive layer included in the cavity distribution layer 70 may also be formed during the wiring formation process of the upper layer 26 after the element module 45 has been embedded.

A manufacturing method of packaging substrate 20 according to one embodiment is described as follows.

The manufacturing method of the packaging substrate comprises a preparation operation of providing a glass core 21 with a cavity portion 28 and an element module 45, and an arrangement operation of placing the element module 45 in the cavity portion 28.

The element module 45 is modularized with one or more cavity elements 40 and a cavity distribution layer 70 by a capsule layer 48. The cavity element 40 may comprise active elements and may further comprise passive elements, as previously described.

The cavity distribution layer 70 is a redistribution layer positioned above the cavity element 40. The cavity distribution layer 70 may comprise at least two or more redistribution distribution circuit layers. The formation of the cavity distribution layer 70 may apply a process in semiconductor manufacturing where redistribution layers are formed.

Detailed descriptions of the cavity distribution layer 70 are omitted as they overlap with the explanations provided above.

The manufacturing method of the packaging substrate may further comprise a core conductive layer operation.

The core conductive layer operation may be performed either between the preparating operation and the arranging operation or after the arranging operation.

The core conductive layer operation is an operation of forming a core conductive layer on the glass core.

The pitch of the redistribution distribution circuit layers 70a, 70b, and 70c may be formed to be narrower than the pitch of the core conductive layer. The pitch of the redistribution distribution circuit layers 70a, 70b, and 70c may increase as the number of layers in the cavity distribution layer increases (i.e., as it moves farther away from the cavity elements).

The element module may be manufactured in a modularization operation.

The modularization operation involves placing procedure of the cavity distribution layer 70 on upper side of the cavity element 40. After this placement, the cavity element 40 and the cavity distribution layer 70 may be encapsulated by the capsule layer 48 in the modularization process.

The cavity distribution layer 70 may comprise at least 2 layers of redistribution distribution circuit layers 70a, 70b, 70c.

The cavity distribution layer may be formed using the SAP (Semi Additive Process) method.

The cavity element is an active element, and the element module may comprise passive elements and be molded (encapsulated).

The manufacturing method may further comprise a pre-molding operation after the modularization operation.

The cavity element may be prepared in its form before dicing, then the cavity distribution layer is formed before being diced, and subsequently encapsulated. The dicing operation is selectively applied when multiple cavity elements are arranged on a single substrate.

The cavity element may be diced, fixed in position through a pre-molding process, and then the cavity distribution layer is formed, and then being encapsulated.

The manufacturing method for the packaging substrate 20 is described in more detail.

A glass core 21 with a cavity portion 28 and an element module 45 is prepared (preparation operation).

The cavity portion 28 is the space where the element module 45 is arranged.

The element module 45 is formed with a cavity distribution layer that comprises at least 2 layers of redistribution distribution circuit layers, which may be prepared in advance through a separate operation.

The cavity distribution layer 70 may be formed by the SAP (Semi Additive Process) method for fine wiring. SAP is a process of forming a circuit pattern by processing via holes on a substrate that combines metal and insulating materials, electroless copper plating, dry film bonding/exposure/development process, and electrolytic copper plating.

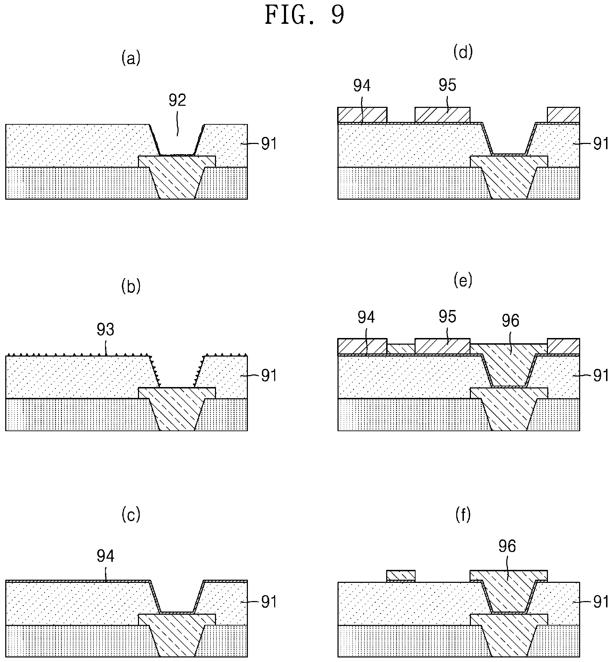

SAP is a process used to form ultra-fine metal wiring, and the process is shown in FIG. 9.

As shown in (a) of FIG. 9, an insulating layer 91 may be formed by a lamination method, and a via 92 may be prepared using a laser or the like. The via 92 may be for forming a via (blind via) of the redistribution distribution circuit layer. The via 92 may be for forming a via (stack via). Additionally, multiple vias 92 may be formed in the same layer for all of these purposes.

Then, optionally, an adhesive 93 may be applied on the insulating layer 91, and the via 92 may be cleaned ((b) of FIG. 9). That is, impurities in the via 92 may be removed. Depending on the embodiment, an adhesive to improve the adhesion of the metal layer to the insulating layer may not be applied.

On the upper side of the adhesive 93, electroless copper may be formed in the form of a metal layer to form a seed layer 94 (seed metallization, (c) of FIG. 9).

Then, after laminating or coating a photoresist such as a dry film on the upper side of the seed layer 94, a photoresist layer 95 having a circuit pattern may be formed through photosensitization ((d) of FIG. 9).

Next, an electrically conductive layer 96 may be formed by plating a metal such as copper in the areas where the dry film photoresist has been removed (e.g., (e) of FIG. 9).

Finally, the dry film photoresist is removed, and the seed layer is removed by flash etching ((f) of FIG. 9).

By repeatedly performing the method as shown in FIG. 9, two or more redistribution circuit layers may be formed on the upper part of the cavity element 40. As the RDL is generated by the SAP method, the pitch of the metal layer (or metal pad) comprised in the redistribution circuit layer of the cavity element 40 may be formed narrower than the pitch of the core metal layer. Additionally, the pitch of the metal layer (or metal pad) comprised in the redistribution distribution circuit layer may be formed narrower than the pitch of the core metal layer.

Furthermore, as the number of layers of the redistribution circuit layer of the cavity element 40 increases, the pitch of the redistribution circuit layer may be widened. That is, as shown in FIG. 7, the metal pad of the redistribution circuit layer may become wider as the number of layers increases, and the width of the metal pad flush with the core metal layer 63 may become similar to the width of the core metal layer.

For example, the width of the cavity bump layer 701, metal terminal of the die, at the bottom may be 40 µm or more, 45 µm or more, 50 µm or more, or 55 µm or more. The width of the cavity bump layer 701, metal terminal of the die, at the bottom may also be 80 µm or less, 75 µm or less, 70 µm or less, 65 µm or less, 60 µm or less, or 55 µm or less.

The width of the electrically conductive layer may gradually increase from the bottom of the distribution layer (cavity distribution layer) of the cavity element 40 to the electrically conductive layer at the bottom of the upper layer.

The size of the pads applied to the stack structure of the thermally conductive layer may gradually increase from the bottom of the distribution layer (cavity distribution layer) of the cavity element 40 to the electrically conductive layer at the bottom of the upper layer.

For example, the width of the electrically conductive layer is as described above.

For example, the width of the electrically conductive layer may be 90 µm or more, 95 µm or more, 100 µm or more, or 105 µm or more at the upper side of the lower layer. The width of the electrically conductive layer may be less than or equal to 180 µm, less than or equal to 175 µm, less than or equal to 170 µm, less than or equal to 165 µm, less than or equal to 160 µm, or less than or equal to 155 µm.

The width of the electrically conductive layer may gradually increase from the lower part of the distribution layer, cavity distribution layer, of the cavity element 40 to the upper part of the electrically conductive layer in the lower layer.

When embedding a cavity element 40 that requires a narrow pitch, specifically an active element, misalignment may occur due to a difference in metal pitch, and in the present embodiment, an alignment margin may be secured by gradually increasing the metal pitch in the wiring layer. In this way, when connecting the cavity element 40 with the core layer 22, a defect that may occur when connecting the semiconductor element and the core layer 22 can be prevented. In other words, by creating a fine RDL in the cavity element 40 in advance and embedding it in the core layer 22 according to the present embodiment, the problem of pitch size can be overcome.

If necessary, once the cavity distribution layer 70 is formed, a dicing process may be performed. Dicing is the process of cutting the diced cavity element 40 into individual ones. In this process, the pre-defined scribe lanes, adequately wide spaces designated to separate chips/dies from the wafer without affecting the surrounding elements, may have no redistribution layers substantially implemented.

One example of a dicing operation may be blade dicing. Blade dicing utilizes a blade, which is a wheel-shaped saw blade, to separate wafers into chips, or strips of processed substrate into individual packages. Blade dicing cuts wafers using a saw blade with diamond grit on the end of the wheel, which creates working tolerances as the blade rotates, so the scribe lane must be thicker than the wheel.

Other operations of dicing comprise laser dicing or plasma dicing. Because blade dicing involves a blade physically contacting the substrate, the substrates are prone to breaking during the process as the required thickness is reduced, so laser dicing was developed. Laser dicing cuts the substrate by irradiating it with a laser, usually from the backside of the substrate. Since the laser cuts the substrate, there is no physical impact, and it is suitable for cutting thin substrates. It also causes less damage to the cut surface, which may increase the strength of the chip.

Plasma dicing is the most recent development in dicing and utilizes plasma etching in the fab process. It is environmentally friendly because it uses a quasi-gaseous material rather than a liquid, and because it is applied to the entire substrate at once, the singulation rate per chip is faster than other dicing processes.

Optionally, after dicing, the cavity element may be encapsulated by pre-molding. The encapsulation operation refers to the operation of wrapping the semiconductor element with a specific material to protect it from the external environment. As one method of encapsulation, molding encloses chips, wires, and the like in an epoxy molding compound (EMC), a material made by mixing various inorganic materials in a thermosetting resin, to protect them from external physical and chemical impacts, and to allow for various package sizes or shapes.

Before the element module 45 is placed in the cavity portion 28, it may be pre-molded prior to final molding to protect and package the cavity elements.

In this process, passive and active elements may be encapsulated together, as shown in FIG. 10.

When the element module 45 is selected (picked) and placed in the cavity portion 28, it may form an upper layer on upper side of the core layer 22 or a lower layer on the lower side of the core layer.

According to an embodiment, once the element module 45 is disposed in the cavity portion 28, the remaining space in the cavity portion 28 may be filled with an insulating material. The insulating material may fill the cavity portion 28 through an insulating layer formation operation that accompanies the operation of forming the distribution layer of the upper layer 26 or the lower layer 80.

FIG. 10 is an example of a cross-sectional structure of a packaging substrate generated according to another embodiment.

According to one embodiment, the element module 45 embedded in the cavity part 28 of the glass core 21 may include passive elements 42 in addition to active elements 41.

The passive element 42 may be encapsulated with the active element when pre-molded. As shown, a cavity distribution layer may not be formed on the upper side of the passive element 42.

In another example, if a cavity distribution layer is also formed on the passive element, the passive element may also be diced after two or more layers of redistribution circuit layers are formed by the SAP method. After dicing, the passive and active elements may be molded together and disposed in the cavity portion 28 of the glass core 21.

Further, the element module may comprise two or more active elements, or may comprise two or more active and passive elements, and may comprise a plurality of passive elements with a distribution layer formed thereon.

A manufacturing method of packaging substrate and a packaging substrate according to the embodiments described above and a packaging substrate utilizing the method can solve misalignment issue due to differences in metal pitch.

The manufacturing method of packaging substrate and a packaging substrate according to the embodiments can significantly reduce a defect rate that may occur during package connection by increasing the pad pitch formed on the cavity element. In addition, the embedding of cavity elements can reduce heat generation and electrical losses by shortening electrical path lengths.

Furthermore, the manufacturing method of the packaging substrate and the packaging substrate according to an embodiment can significantly reduce the failure rate that may occur during package connection by increasing the pad pitch formed on the cavity element.

Further, the manufacturing method of packaging substrate and the packaging substrate according to an embodiment can reduce heat generation and electrical losses by shortening electrical path lengths through the embedding of the cavity elements.

The above-described disclosure has been described with reference to the embodiments shown in the drawings, but these are exemplary only, and those having ordinary knowledge in the art will understand that various modifications and variations of the embodiments are possible from them. In other words, the scope of the disclosure is not limited to the embodiments described above, but also to various modifications and improvements of the embodiments and embodiments of those skilled in the art utilizing the basic concepts of the embodiments defined in the following claims. Accordingly, the true technical scope of the disclosure is to be determined by the technical ideas of the appended claims.

## Claims

1. A packaging substrate, comprising a core layer,
wherein the core layer comprises a glass core having first and second surfaces facing each other and a cavity portion penetrating the glass core,
wherein an element module is disposed in the cavity portion,
wherein the element module comprises one or more cavity elements and a cavity distribution layer that are modularized into a capsule layer,
wherein the cavity distribution layer is disposed above the cavity element, and the cavity distribution layer comprises a redistribution distribution circuit layer.

2. The packaging substrate of Claim 1,
wherein the cavity distribution layer comprises at least two or more redistribution circuit layers,
the redistribution circuit layer comprises : i) a cavity bump layer; or ii) a via and a circuit layer,
the cavity bump layer is a bump layer that is in contact with an upper part of the cavity element, allowing for the transmission of electrical signals to the cavity element, and
the via and the circuit layers are electrically conductive layers that transmit electrical signals from the cavity bump layer to the outside of the element module.

3. The packaging substrate of Claim 2,
wherein the cavity distribution layer comprises:
a first redistribution circuit layer where the cavity bump layer is arranged; a second redistribution circuit layer where a first via and a first circuit layer are embedded within a module insulation layer; and a third redistribution circuit layer where a second via and a second circuit layer are embedded within the module insulation layer,
wherein the module insulation layer is an insulating layer arranged within the element module.

4. The packaging substrate of Claim 2 or Claim 3,
wherein the glass core has a core electrically conductive layer, in which a metal circuit pattern is arranged on the surface of the glass core, and
the pitch of the redistribution circuit layers is narrower than the pitch of the core electrically conductive layer.

5. The packaging substrate of Claim 3 or Claim 4,
wherein a pitch of the second circuit layer is larger than the pitch of the first circuit layer.

6. The packaging substrate of any one from Claim 3 to Claim 5,
wherein the first redistribution circuit layer and the second redistribution circuit layer have metal pads respectively, and an area of the metal pad of the second redistribution circuit layer is larger than an area of the metal pad of the first redistribution circuit layer.

7. The packaging substrate of any one from Claim 1 to Claim 6,
wherein the element module comprises an active element.

8. The packaging substrate of Claim 7,
wherein the element module further comprises passive element.

9. The packaging substrate of any one from Claim 1 to Claim 8, further comprising an upper layer which is disposed of upper side of the core layer, and
wherein the pitch of the electrically conductive pattern arranged on the bottom surface of the upper layer is greater than the minimum pitch of the cavity distribution layer.

10. The packaging substrate of any one from Claim 1 to Claim 9, further comprising a lower layer positioned beneath the core layer, and a pitch of the electrically conductive pattern arranged on the upper surface of the lower layer is greater than the minimum pitch of the cavity distribution layer.

11. A manufacturing method of a packaging substrate, comprising
preparing operation of a glass core with a cavity portion and an element module; and arranging operation of the element module in the cavity portion,
wherein the element module is modularized with one or more cavity elements and a cavity distribution layer encapsulated in a capsule layer, and the cavity distribution layer is a distribution layer disposed on an upper surface of the cavity element.

12. The manufacturing method of Claim 11,
wherein the cavity distribution layer comprises at least two or more redistribution circuit layers,
the redistribution circuit layer comprises : i) a cavity bump layer; or ii) a via and a circuit layer,
the cavity bump layer is a bump layer that is in contact with an upper part of the cavity element, allowing for the transmission of electrical signals to the cavity element, and
the via and the circuit layers are electrically conductive layers that transmit electrical signals from the cavity bump layer to the outside of the element module.

13. The manufacturing method of Claim 11 or Claim 12,
wherein pitch of the redistribution circuit layer widens as it extends away from the cavity distribution layer and the cavity element.

14. The manufacturing method of any one from Claim 11 to Claim 13,
wherein the element module is manufactured in the modularization operation, and the modularization operation is the process of placing the cavity distribution layer on upper side of the cavity element,
wherein the cavity distribution layer comprises a redistribution circuit layer, and the redistribution circuit layer is formed applying the Semi Additive Process (SAP) method.

15. The manufacturing method of Claim 11 to Claim 14,
wherein the element module comprises an active element, and
wherein the element module further comprises passive element.
